# EUROPEAN PATENT SPECIFICATION

(11) **EP 4 109 523 B1**
(45) Date of publication and mention of the grant of the patent: **17.12.2025**
(21) Application number: 22169729.5
(22) Date of filing: 25.04.2022
(51) Int. Cl.: H10D 84/01, H01L 23/535, H01L 23/528, H01L 21/74, H10D 84/85, H01L 23/48, H01L 21/768

(54) **BURIED POWER RAIL WITH A SILICIDE LAYER FOR WELL BIASING**
VERGRABENE STROMSCHIENE MIT EINER SILIZIDSCHICHT FÜR WANNENVORSPANNUNG
RAIL D'ALIMENTATION ENTERRÉ AVEC UNE COUCHE DE SILICIURE POUR LA POLARISATION DES PUITS

(30) Priority: 25.06.2021 US 202117358551
(43) Date of publication of application: 28.12.2022
(73) Proprietor: INTEL Corporation, Santa Clara, CA 95054 (US)
(72) Inventor: PARK, Changyok, Portland, 97229 (US); WEI, Andy Chih-Hung, Yamhill, 97148 (US)
(74) Representative: Goddar, Heinz J.

(56) References cited:
- US-A1- 2002 020 862
- US-A1- 2009 050 972
- US-A1- 2020 176 448
- US-A1- 2021 028 112

## Description

### FIELD

Embodiments of the present disclosure generally relate to the field of semiconductor fabrication, and in particular to well biasing for circuit structures.

### BACKGROUND

Continued growth in portable electronic devices will continue to increase the demand for high-quality transistor implementations.
US 2020/176448 A1 describes a semiconductor arrangement which includes a well region, a transistor over the well region, a conductive line in conductive contact with a first source/drain region of the transistor and having a sidewall in conductive contact with a sidewall of the well region, and a liner layer disposed between the sidewall of the conductive line and the sidewall of the well region.
US 2009/050972 A1 describes a method of making a semiconductor device. A semiconductor body, a gate electrode and source/drain regions are provided. A liner is provided that covers the gate electrode and the source/drain regions. Silicide regions are formed on the semiconductor device by etching a contact hole through the liner.
US 2002/020862 A1 describes a backside interconnect structure used to deliver power through the substrate to the front side of an integrated circuit. One or more power planes are formed on the backside of the substrate and coupled to power nodes on the front side by deep vias in the substrate. In a specific embodiment of the invention, power planes are coupled through the substrate to front side metal lines, well taps and external connection points. Placing power planes on the opposite side of the substrate from the signal interconnects allows the use of low dielectric constant materials between signal lines, while using high dielectric constant materials between power planes thus increasing decoupling capacitance without increasing parasitic capacitance between signal lines.
US 2021/028112 A1 describes a semiconductor device including a substrate having a first surface and a second surface opposite to each other, and having an active region located on the first surface and defined by a first isolation region; a plurality of active fins arranged on the active region, extending in a first direction, and defined by a second isolation region having a second depth smaller than a first depth of the first isolation region; a buried conductive wiring in a trench adjacent to the plurality of active fins, and extending in a direction of the trench; a filling insulation portion in the trench, and having the buried conductive wiring therein; an interlayer insulation layer on the first and second isolation regions and on the buried conductive wiring; a contact structure penetrating the interlayer insulation layer, and contacting the buried conductive wiring; and a conductive through structure extending through the substrate from the second surface to the trench, and contacting the buried conductive wiring.
The invention is set forth in the independent claims. Embodiments of the invention are described in the dependent claims.

### BRIEF DESCRIPTION OF THE DRAWINGS

FIG. 1 illustrates a side view of a circuit structure that includes a buried power rail (BPR) within a well, with a silicide layer between the BPR and the well, in accordance with various embodiments.
FIG. 2A-2O illustrate stages in the manufacture of a circuit structure with a BPR within a well with a silicide layer between the BPR and the well, in accordance with various embodiments.
FIG. 3 illustrates a side view of a circuit structure with a BPR within a well with a silicide layer between the BPR and the well, where the BPR is electrically coupled at a bottom side of the circuit structure, in accordance with various embodiments.
FIG. 4 illustrates an example process for manufacturing a power rail with a silicide layer for well biasing, in accordance with various embodiments.
FIG. 5 illustrates a computing device 500 in accordance with one implementation of the invention.
FIG. 6 illustrates an interposer 600 that includes one or more embodiments of the invention.

### DETAILED DESCRIPTION

Embodiments described herein may be related to apparatuses, processes, and techniques for well biasing using a buried power rail (BPR) within a circuit structure. Embodiments include using a silicide material between the BPR conductor and a well, which may be doped silicon, where the silicide material provides ohmic contact between the BPR conductor and the well. This allows any excessive built-up charges, or noise to be prevented from entering a circuit and preventing latch-up in complementary metal oxide semiconductor (CMOS) circuits. A latch up is a type of short-circuit resulting from the inadvertent creation of a low impedance path between power rails. This may result in disrupting proper functioning of the circuit, and may lead to damage due to an over current situation.

Legacy implementations have used a tap cell to bias a well in a circuit structure, for example using Vdd for an n-well and Vss for a p-well. Disadvantages of this legacy approach is that it may consume 2-3% of a system-on-a-chip (SOC) area, even with tens of microns of spacing between the tap cells.

In embodiments, the ohmic contact created by the silicide material between the BPR conductor and Vdd for n-well and Vss for p-well, instead of using dielectric isolation to separate the BPR from the well, will allow the BPR conductor to be used for well biasing. Not only will this allow tap cells to be removed from the circuit structure and the overall SOC area reduced, embodiments will improve latch up protection throughout the circuit structure due to the spread of the BPR throughout the circuit structure. In addition, because the silicide metal may be coated everywhere between the BPR and the well, there is much better coverage for ohmic contact.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

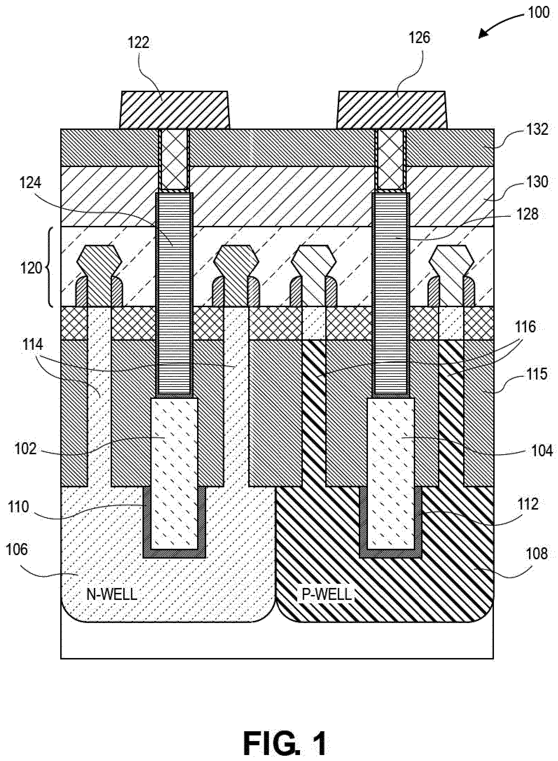

FIG. 1 illustrates a side view of a circuit structure that includes a buried power rail (BPR) within a well, with a silicide metal layer between the BPR and the well, in accordance with various embodiments. Circuit structure 100 shows a first BPR 102 and a second BPR 104 that are partially embedded into wells. The first BPR 102 is embedded into n-well 106, and the second BPR 104 is embedded into p-well 108.

Silicide metal layers 110, 112 may be placed, respectively, between BPR 102 and n-well 106, and BPR 104 and p-well 108. In embodiments, the silicide metal layer may include, for example but not limited to, titanium (Ti), cobalt (Co), or nickel (Ni). In embodiments, the silicide metal layers 110, 112 may be evenly distributed around a portion of the BPR 102, 104, may be distributed with varying thicknesses around the BPR 102, 104, or may be partially distributed around the BPR 102, 104.

In embodiments, the n-well 106 and p-well 108 may include silicon. N-well 106 may have multiple fins 114, and p-well 108 may have multiple fins 116 that extend toward the top of the circuit structure 100. In embodiments, the BPR 102 may be located between the n-well fins 114, and the BPR 104 may be located between the p-well fins 116. Transistor structures within layer 120 may be coupled with the fins 114, 116. Dielectric material 115 may separate the fins 114, 116 and BPR 102, 104.

The BPR 102 may be electrically coupled with a Vdd power source 122 by an electrical connector 124 extending toward the top of the circuit structure 100. The BPR 104 may be electrically coupled with a Vss power source 126 by an electrical connector 128. In other embodiments, as described below, an electrical connector may extend from the BPR 102, 104 through the n-well 106 or p-well 108 through the bottom of the circuit structure 100.

In embodiments, a layer 130, and a layer 132, which are insulator materials, may be below the Vdd power source 122 and the Vss power source 126.

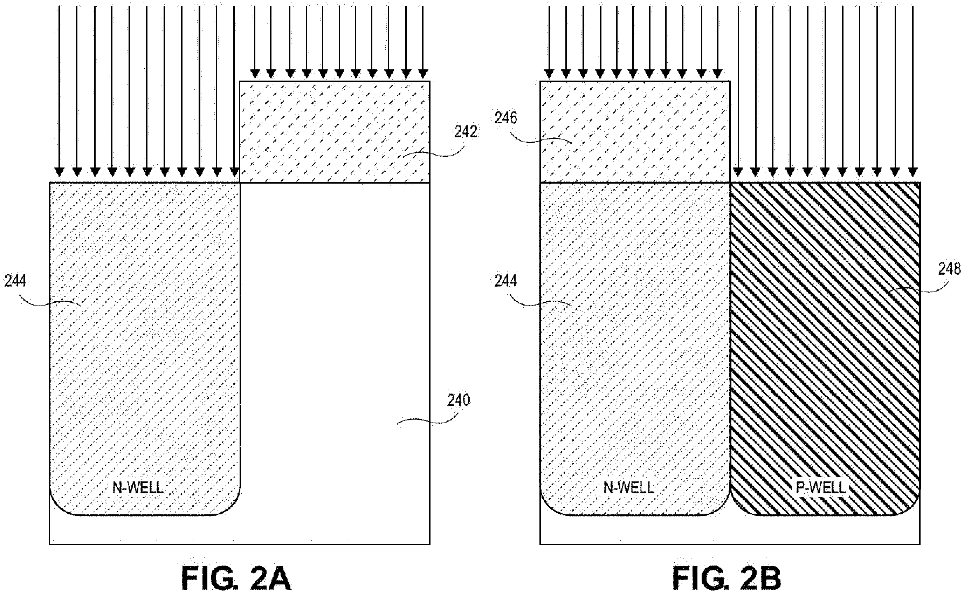

FIG. 2A-2O illustrate stages in the manufacture of a circuit structure with a BPR within a well with a silicide metal layer between the BPR and the well, in accordance with various embodiments. FIG. 2A illustrates a manufacturing stage of creating the circuit structure by performing a well implant to create an n-well, such as n-well 106 of FIG. 1. A block of silicon 240 may have a first side of the top surface capped with a mask 242. The implant process using phosphorus may then begin, forming a n-well area 244, which may be similar to n-well 106.

FIG. 2B illustrates a manufacturing stage of creating the circuit structure by performing a well implant to create a p-well, such as p-well 108 of FIG. 1. The mask 242 of FIG. 2A is removed, and another mask 246 is placed over the newly created n-well 244. The implant process using boron may then begin, forming a p-well area 248, which may be similar to p-well 108 of FIG. 1.

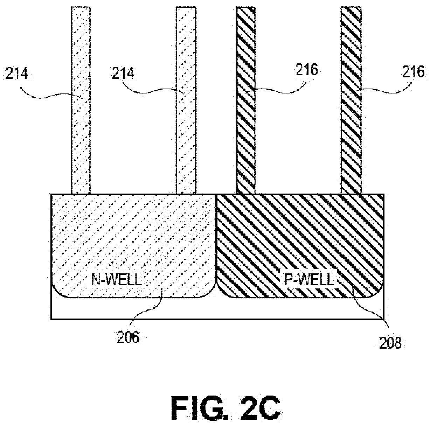

FIG. 2C illustrates a manufacturing stage of creating the circuit structure by performing an etch to create fins 214 above the etched n-well 206, and to create fins 216 above the etched p-well 208. In embodiments, the fins 214 and the fins 216 may be similar to, respectively, fins 114 and fins 116 of FIG. 1. The etched n-well 206 and the etched p-well 208 may be similar to, respectively, n-well 106 and p-well 108 of FIG. 1.

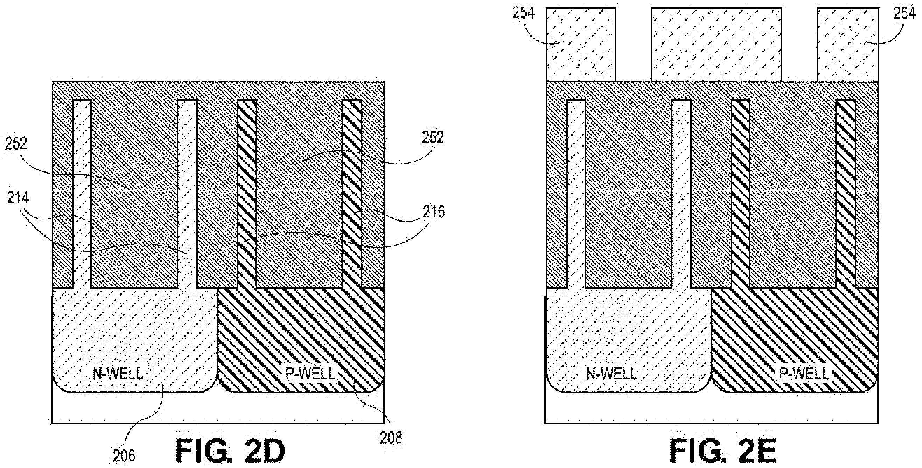

FIG. 2D illustrates a manufacturing stage of creating the circuit structure by depositing an isolation oxide 252 above the n-well 206, above the p-well 208, and above and between fins 214, 216.

FIG. 2E illustrates a manufacturing stage of creating a circuit structure by depositing a mask 254 on top of the isolation oxide 252. In embodiments, the mask may include organic photoresist or other materials which would be selective to oxide during oxide etch.

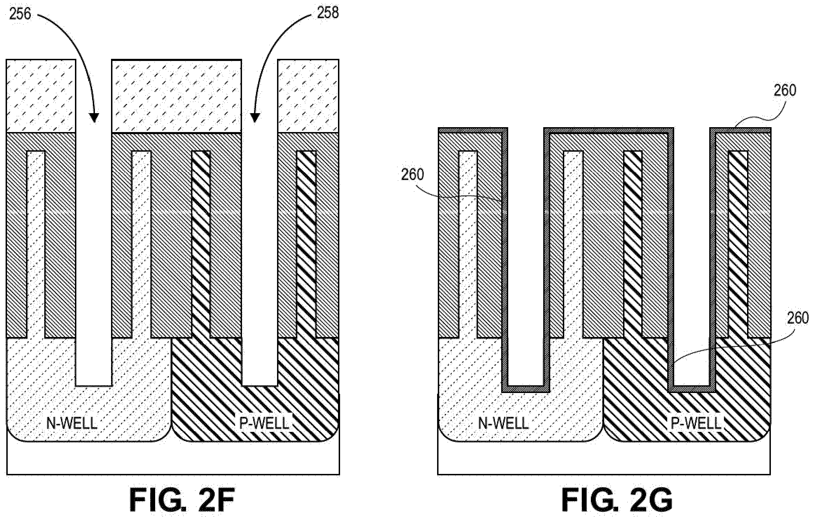

FIG. 2F illustrates a manufacturing stage of creating a circuit structure by etching cavities 256, 258 in preparation for forming, respectively, BPR 102, 104 of FIG. 1 using a deposition process.

FIG. 2G illustrates a manufacturing stage of creating a circuit structure by depositing silicide metal 260 on the surface of the circuit structure and also on the walls and floors of the cavities 256, 258. In embodiments, the silicide metal 260 may include Ti, Co, or Ni, but is not limited to these metals.

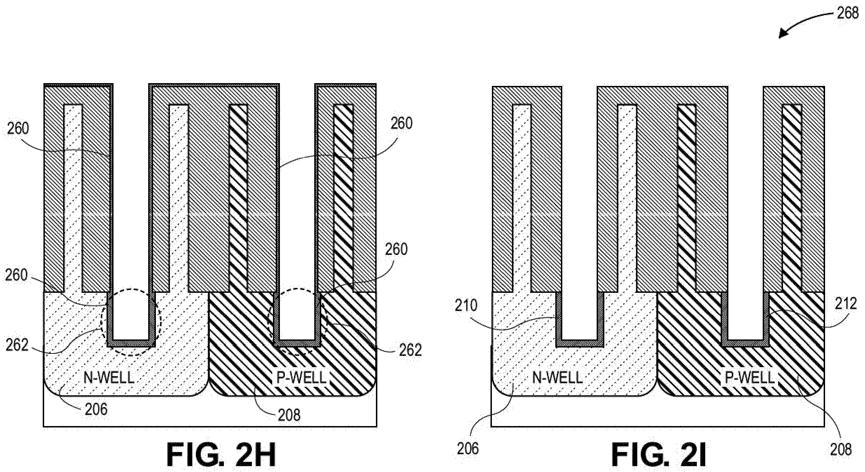

FIG. 2H illustrates a manufacturing stage of creating a circuit structure by performing a silicidation process. The silicidation process causes the deposited silicide metal from FIG. 2G to be impregnated within areas of silicon onto which the silicide metal was deposited. For example, regions 262 show areas where the silicide metal 260 is deposited next to silicon within the n-well 206 and the p-well 208. In embodiments, the silicidation involves heating the circuit structure.

FIG. 2I illustrates a manufacturing stage of creating a circuit structure by removing the excess silicide metal 260 from FIG. 2H. This includes the excess silicide metal 260 that may be deposited next to a dielectric material and not form silicide as described above with respect to FIG. 2G. After removal of the excess silicide metal 260, silicide layer 210, 212 are left, respectively, within n-well 206 and p-well 208.

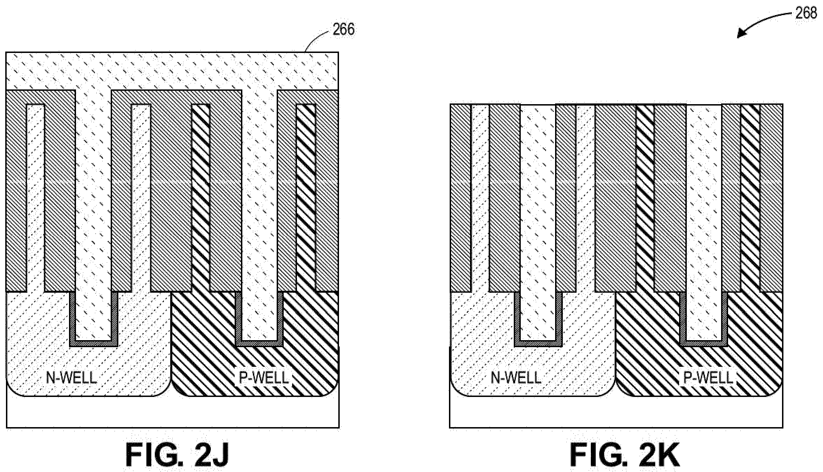

FIG. 2J illustrates a manufacturing stage of creating a circuit structure by depositing a conductive metal 266 onto the circuit structure. The conductive metal 266 is used to form the BPR 102, 104 of FIG. 1 in subsequent manufacturing stages.

FIG. 2K illustrates a manufacturing stage of creating a circuit structure by performing a polish, for example a chemical metal polish (CMP), to remove excess deposited conductive metal 266 and to leave a top surface 268 of the circuit structure level.

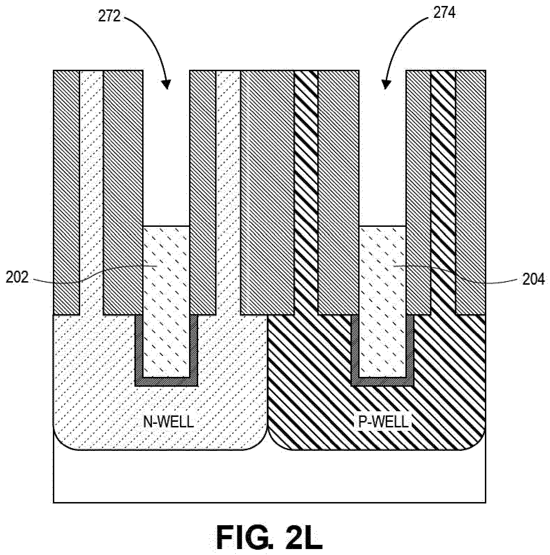

FIG. 2L illustrates a manufacturing stage of creating a circuit structure by etching the deposited conductive metal 266 to create cavities 272, 274 above, respectively, BPRs 202, 204. BPRs 202, 204 may be similar to BPRs 102, 104 of FIG. 1.

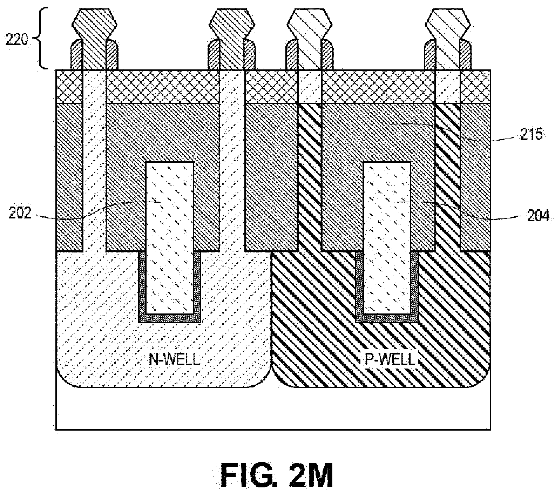

FIG. 2M illustrates a manufacturing stage of creating a circuit structure by filling the cavities 272, 274 with a dielectric material 215, which may be similar to dielectric material 252 of FIG. 2D, or dielectric material 115 of FIG. 1. Subsequently, a layer 220 of transistor structures, which may be similar to layer 120 of FIG. 1, may be applied to the top of the circuit structure.

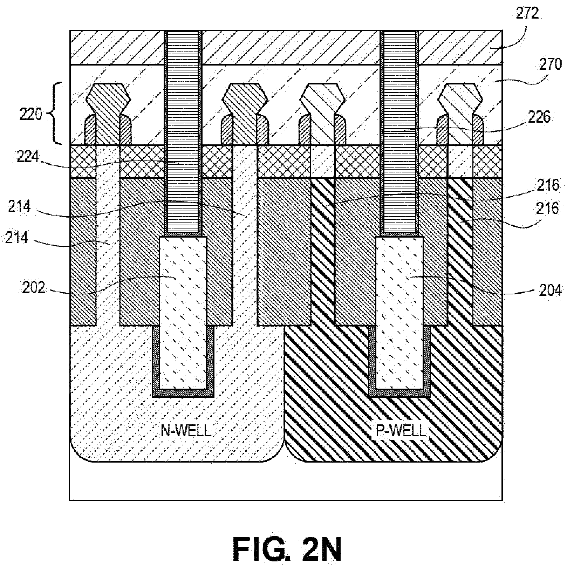

FIG. 2N illustrates a manufacturing stage of creating a circuit structure that includes the creation of electrical connectors 224, 226. In embodiments, cavity may be made from the top of the circuit structure to a top of the BPR 202, into which a conductive material is placed to form electrical connector 224. Similarly, another cavity may be made from the top of the circuit structure to a top of the BPR 204, into which a conductive material is placed to form electrical connector 226. The electrical connector 224 will electrically couple with the BPR 202, and the electrical connector 226 will electrically couple with the BPR 204. FIG. 2N also shows the application of a dielectric layer 270 and the application of a dielectric layer 272 at the top of the circuit structure.

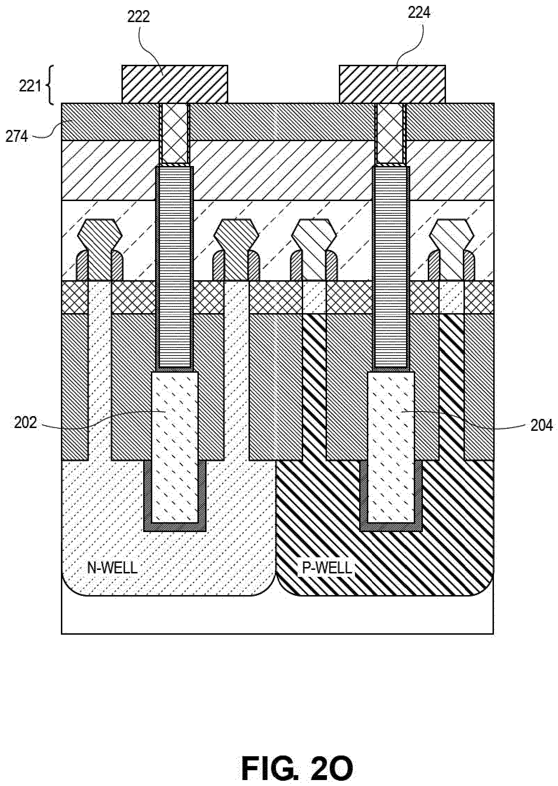

FIG. 2O illustrates a manufacturing stage of creating a circuit structure, that includes connecting power to the BPR 202, 204. In embodiments, a dielectric layer 274 may be added to a top of the dielectric layer 272 of FIG. 2N, onto which a power grid layer 221 that includes a Vdd 222 and a Vss 224 are electrically coupled, respectively, to BPRs 202, 204.

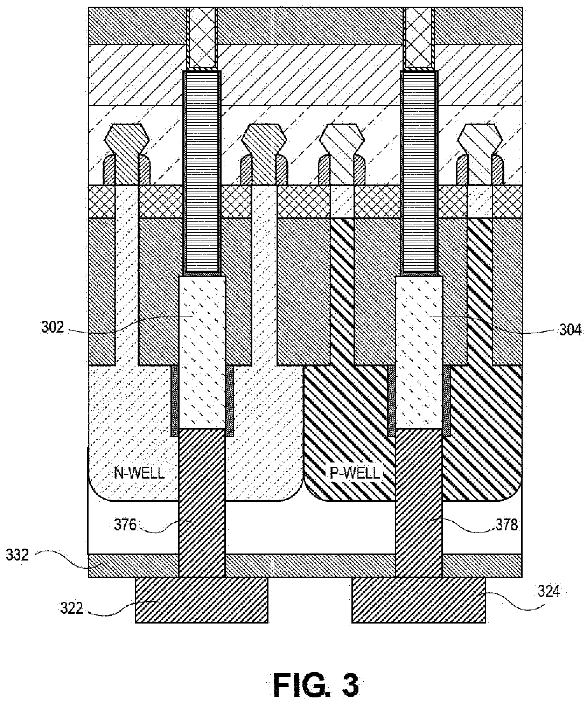

FIG. 3 illustrates a side view of a circuit structure with a BPR within a well with a silicide metal layer between the BPR and the well, where the BPR is electrically coupled at a bottom side of the circuit structure, in accordance with various embodiments according to the invention. The Vss 324 is electrically coupled with the bottom side of the BPR 304 through a nano through silicon via (TSV) 378. Similarly, the Vdd 322 is electrically coupled with the bottom side of the BPR 302 through a nano TSV 376. Both the Vss 324 and Vdd 322 are on an insulating layer 332, which may be similar to insulating layer 132 of FIG. 1.

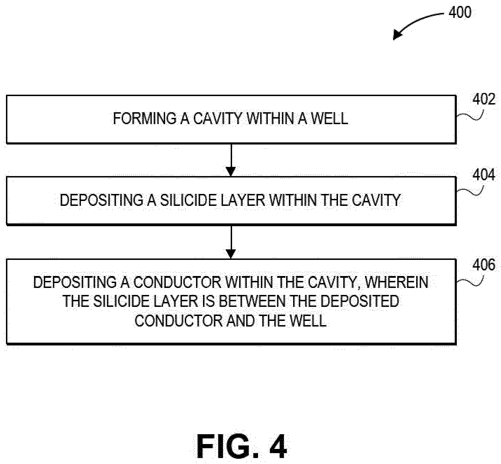

FIG. 4 illustrates an example process for manufacturing a power rail with a silicide layer for well biasing, in accordance with various embodiments. Process 400 may be performed by anyone of the apparatus, systems, techniques, or processes described herein, and in particular with respect to FIGs. 1-3.

At block 402, the process may include forming a cavity within a well.

At block 404, the process may further include depositing a silicide metal layer within the cavity and form silicide on well regions.

At block 406, the process may further include depositing a conductor within the cavity, wherein the silicide layer is formed between the deposited conductor and the well.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

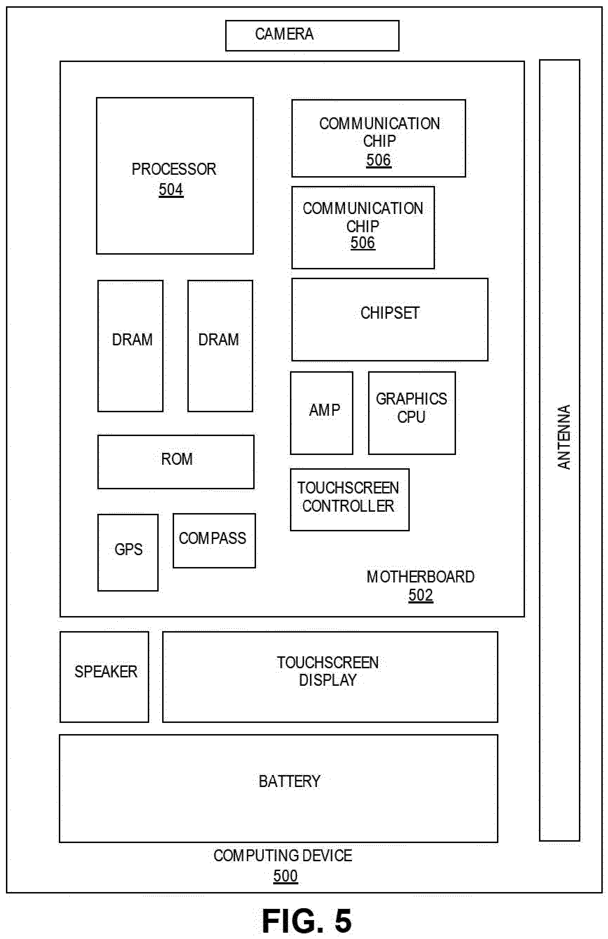

FIG. 5 illustrates a computing device 500 in accordance with one implementation of the invention. The computing device 500 houses a board 502. The board 502 may include a number of components, including but not limited to a processor 504 and at least one communication chip 506. The processor 504 is physically and electrically coupled to the board 502. In some implementations the at least one communication chip 506 is also physically and electrically coupled to the board 502. In further implementations, the communication chip 506 is part of the processor 504.

Depending on its applications, computing device 500 may include other components that may or may not be physically and electrically coupled to the board 502. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 506 enables wireless communications for the transfer of data to and from the computing device 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing device 500 includes an integrated circuit die packaged within the processor 504. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 506 also includes an integrated circuit die packaged within the communication chip 506. In accordance with another implementation of the invention, the integrated circuit die of the communication chip includes one or more devices, such as MOS-FET transistors built in accordance with implementations of the invention.

In further implementations, another component housed within the computing device 500 may contain an integrated circuit die that includes one or more devices, such as MOS-FET transistors built in accordance with implementations of the invention.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

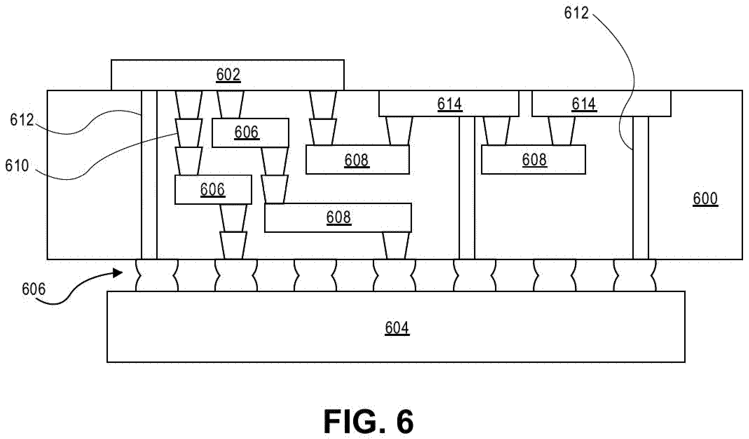

FIG. 6 illustrates an interposer 600 that includes one or more embodiments of the invention. The interposer 600 is an intervening substrate used to bridge a first substrate 602 to a second substrate 604. The first substrate 602 may be, for instance, an integrated circuit die. The second substrate 604 may be, for instance, a memory module, a computer motherboard, or another integrated circuit die. Generally, the purpose of an interposer 600 is to spread a connection to a wider pitch or to reroute a connection to a different connection. For example, an interposer 600 may couple an integrated circuit die to a ball grid array (BGA) 606 that can subsequently be coupled to the second substrate 604. In some embodiments, the first and second substrates 602/604 are attached to opposing sides of the interposer 600. In other embodiments, the first and second substrates 602/604 are attached to the same side of the interposer 600. And in further embodiments, three or more substrates are interconnected by way of the interposer 600.

The interposer 600 may be formed of an epoxy resin, a fiberglass-reinforced epoxy resin, a ceramic material, or a polymer material such as polyimide. In further implementations, the interposer 600 may be formed of alternate rigid or flexible materials that may include the same materials described above for use in a semiconductor substrate, such as silicon, germanium, and other group III-V and group IV materials.

The interposer 600 may include metal interconnects 608 and vias 610, including but not limited to through-silicon vias (TSVs) 612. The interposer 600 may further include embedded devices 614, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 600. In accordance with embodiments of the invention, apparatuses or processes disclosed herein may be used in the fabrication of interposer 600.

## Claims

1. A circuit structure comprising:
a well (206, 208);
a power rail (302, 304) partially located within the well (206, 208);
an electrical connector (224, 226) electrically coupled with the top of the power rail (302, 304);
a nano through silicon via (376, 378) electrically coupled with the bottom side of the power rail (302, 304), the nano through silicon via (376, 378) electrically coupling the power rail (202, 204) with VSS (324) or VDD (322) provided on an insulating layer (332) below the underside of the well (206, 208); and
a silicide layer (260) between the power rail (302, 304) and the well (206, 208).

2. The circuit structure of claim 1, wherein the silicide layer (260) has a thickness between 2nm and 10nm.

3. The circuit structure of claim 1, wherein the silicide layer (260) is a continuous metallic layer.

4. The circuit structure of claim 1, wherein the well (206, 208) is a selected one of: an n-well (206, 208) or a p-well (206, 208).

5. The circuit structure of claim 1, wherein the well (206, 208) includes silicon.

6. The circuit structure of claim **1,** were in the silicide layer (260) includes at least one of titanium (Ti), cobalt (Co), or nickel (Ni).

7. The circuit structure of claim **1,** further comprising:
a first fin and a second fin substantially parallel with the first fin, the first fin and the second fin extending from the well (206, 208), wherein the power rail (202, 204) is at least partially disposed between the first fin and the second fin.

8. The circuit structure of claim 1, wherein the electrical connector is electrically coupled with a side of the power rail (202, 204) opposite a side of the power rail (202, 204) located within the well (206, 208).

9. The circuit structure of claim 8, wherein the electrical connector is coupled with a power source.

10. A method comprising:
forming a cavity within a well (206, 208);
depositing a silicide metal layer within the cavity; and
depositing a conductor within the cavity, wherein the silicide layer (260) is between the deposited conductor and the well (206, 208)
forming an electrical connector electrically coupled with the top of the power rail (202, 204);
forming a nano through silicon via (376, 378) electrically coupled with the bottom side of the conductor (202, 204), the nano through silicon via (376, 378) electrically coupling the conductor (202, 204) with VSS or VDD provided on an insulating layer (332) below the underside of the well (206, 208).

11. The method of claim 10, wherein depositing the silicide metal layer within the cavity further includes forming the silicide layer (260) to a wall of the cavity with a silicidation process.

12. The method of claim 10, wherein forming a cavity within a well (206, 208) further comprises:
etching silicon within the well (206, 208).

13. The method of claim 10, wherein forming a cavity within the well (206, 208) further comprises forming a first fin and a second fin substantially parallel with the first fin that are coupled with the well (206, 208), wherein the cavity is between the first fin and the second fin.

## Patentansprüche

1. Schaltungsstruktur, umfassend:
eine Wanne (206, 208);
eine Stromschiene (302, 304), die sich teilweise innerhalb der Wanne (206, 208) befindet;
einen elektrischen Verbinder (224, 226), der elektrisch mit der Oberseite der Stromschiene (302, 304) gekoppelt ist;
eine Nano-Silicium-Durchkontaktierung (376, 378), die elektrisch mit der Unterseite der Stromschiene (302, 304) gekoppelt ist, wobei die Nano-Silicium-Durchkontaktierung (376, 378) die Stromschiene (202, 204) elektrisch mit VSS (324) oder VDD (322) koppelt, die auf einer Isolationsschicht (332) unter der Unterseite der Wanne (206, 208) vorgesehen ist; und
eine Silicidschicht (260) zwischen der Stromschiene (302, 304) und der Wanne (206, 208).

2. Schaltungsstruktur nach Anspruch 1, wobei die Silicidschicht (260) eine Dicke zwischen 2 nm und 10 nm aufweist.

3. Schaltungsstruktur nach Anspruch 1, wobei die Silicidschicht (260) eine durchgehende metallische Schicht ist.

4. Schaltungsstruktur nach Anspruch 1, wobei die Wanne (206, 208) eine ist, die aus folgenden ausgewählt ist: einer n-Wanne (206, 208) oder einer p-Wanne (206, 208).

5. Schaltungsstruktur nach Anspruch 1, wobei die Wanne (206, 208) Silicium aufweist.

6. Schaltungsstruktur nach Anspruch 1, wobei die Silicidschicht (260) mindestens eines von Titan (Ti), Cobalt (Co) oder Nickel (Ni) aufweist.

7. Schaltungsstruktur nach Anspruch 1, ferner umfassend:
eine erste Finne und eine zweite Finne im Wesentlichen parallel zu der ersten Finne, wobei sich die erste Finne und die zweite Finne aus der Wanne (206, 208) erstrecken, wobei die Stromschiene (202, 204) zumindest teilweise zwischen der ersten Finne und der zweiten Finne angeordnet ist.

8. Schaltungsstruktur nach Anspruch 1, wobei der elektrische Verbinder elektrisch mit einer Seite der Stromschiene (202, 204) gegenüber einer Seite der Stromschiene (202, 204) gekoppelt ist, die sich innerhalb der Wanne (206, 208) befindet.

9. Schaltungsstruktur nach Anspruch 8, wobei der elektrische Verbinder mit einer Leistungsquelle gekoppelt ist.

10. Verfahren, umfassend:
Bilden eines Hohlraums innerhalb einer Wanne (206, 208); Abscheiden einer Silicidmetallschicht innerhalb des Hohlraums; und
Abscheiden eines Leiters innerhalb des Hohlraums, wobei sich die Silicidschicht (260) zwischen dem abgeschiedenen Leiter und der Wanne (206, 208) befindet;
Bilden eines elektrischen Verbinders, der elektrisch mit der Oberseite der Stromschiene (202, 204) gekoppelt ist;
Bilden einer Nano-Silicium-Durchkontaktierung (376, 378), die elektrisch mit der Unterseite des Leiters (202, 204) gekoppelt ist, wobei die Nano-Silicium-Durchkontaktierung (376, 378) den Leiter (202, 204) elektrisch mit VSS oder VDD koppelt, die auf einer Isolationsschicht (332) unter der Unterseite der Wanne (206, 208) vorgesehen ist.

11. Verfahren nach Anspruch 10, wobei das Abscheiden der Silicidmetallschicht innerhalb des Hohlraums ferner Bilden der Silicidschicht (260) an einer Wand des Hohlraums mit einem Silicidierungsprozess aufweist.

12. Verfahren nach Anspruch 10, wobei das Bilden eines Hohlraums innerhalb einer Wanne (206, 208) ferner Folgendes umfasst:
Ätzen von Silicium innerhalb der Wanne (206, 208).

13. Verfahren nach Anspruch 10, wobei das Bilden eines Hohlraums innerhalb der Wanne (206, 208) ferner Bilden einer ersten Finne und einer zweiten Finne im Wesentlichen parallel zu der ersten Finne umfasst, die mit der Wanne (206, 208) gekoppelt sind, wobei sich der Hohlraum zwischen der ersten Finne und der zweiten Finne befindet.

## Revendications

1. Structure de circuit, comprenant :
un puits (206, 208) ;
un rail d'alimentation (302, 304) situé partiellement à l'intérieur du puits (206, 208) ;
un connecteur électrique (224, 226) couplé électriquement au sommet du rail d'alimentation (302, 304) ;
un nano-via traversant le silicium (376, 378) couplé électriquement au côté inférieur du rail d'alimentation (302, 304), le nano-via traversant le silicium (376, 378) couplant électriquement le rail d'alimentation (202, 204) à la VSS (324) ou la VDD (322) fournie sur une couche d'isolation (332) sous la face inférieure du puits (206, 208) ; et
une couche de siliciure (260) entre le rail d'alimentation (302, 304) et le puits (206, 208).

2. Structure de circuit selon la revendication 1, dans laquelle la couche de siliciure (260) a une épaisseur comprise entre 2 nm et 10 nm.

3. Structure de circuit selon la revendication 1, dans laquelle la couche de siliciure (260) est une couche métallique continue.

4. Structure de circuit selon la revendication 1, dans laquelle le puits (206, 208) est un puits choisi parmi : un puits n (206, 208) ou un puits p (206, 208).

5. Structure de circuit selon la revendication 1, dans laquelle le puits (206, 208) inclut du silicium.

6. Structure de circuit selon la revendication 1, dans laquelle la couche de siliciure (260) inclut au moins un élément parmi le titane (Ti), le cobalt (Co) ou le nickel (Ni).

7. Structure de circuit selon la revendication 1, comprenant en outre :
une première ailette et une seconde ailette sensiblement parallèle à la première ailette, la première ailette et la seconde ailette s'étendant à partir du puits (206, 208), dans laquelle le rail d'alimentation (202, 204) est au moins partiellement disposé entre la première ailette et la seconde ailette.

8. Structure de circuit selon la revendication 1, dans laquelle le connecteur électrique est couplé électriquement à un côté du rail d'alimentation (202, 204) opposé à un côté du rail d'alimentation (202, 204) situé à l'intérieur du puits (206, 208).

9. Structure de circuit selon la revendication 8, dans laquelle le connecteur électrique est couplé à une source d'alimentation.

10. Procédé comprenant :
le formage d'une cavité à l'intérieur d'un puits (206, 208) ;
le dépôt d'une couche métallique de siliciure à l'intérieur de la cavité ; et
le dépôt d'un conducteur à l'intérieur de la cavité, dans lequel la couche de siliciure (260) se trouve entre le conducteur déposé et le puits (206, 208) ;
le formage d'un connecteur électrique couplé électriquement au sommet du rail d'alimentation (202, 204) ;
le formage d'un nano-via traversant le silicium (376, 378) couplé électriquement au côté inférieur du conducteur (202, 204), le nano-via traversant le silicium (376, 378) couplant électriquement le conducteur (202, 204) à la VSS ou la VDD fournie sur une couche d'isolation (332) sous la face inférieure du puits (206, 208).

11. Procédé selon la revendication 10, dans lequel le dépôt de la couche métallique de siliciure à l'intérieur de la cavité inclut en outre le formage de la couche de siliciure (260) sur une paroi de la cavité avec un processus de siliciuration.

12. Procédé selon la revendication 10, dans lequel le formage d'une cavité à l'intérieur d'un puits (206, 208) comprend en outre :
la gravure de silicium à l'intérieur du puits (206, 208).

13. Procédé selon la revendication 10, dans lequel le formage d'une cavité à l'intérieur du puits (206, 208) comprend en outre le formage d'une première ailette et d'une seconde ailette sensiblement parallèle à la première ailette qui sont couplées au puits (206, 208), dans lequel la cavité se trouve entre la première ailette et la seconde ailette.
